# EUROPEAN PATENT APPLICATION

(11) **EP 4 109 524 A1**
(43) Date of publication of application: **28.12.2022**
(21) Application number: 22159631.5
(22) Date of filing: 02.03.2022
(51) Int. Cl.: H01L 25/065, H01L 23/00

(54) **APPARATUS AND METHOD TO INTEGRATE THREE-DIMENSIONAL PASSIVE COMPONENTS BETWEEN DIES**

(30) Priority: 25.06.2021 US 202117359481
(71) Applicant: INTEL Corporation, Santa Clara, CA 95054 (US)
(72) Inventor: DOGIAMIS, Georgios, Chandler, 85226 (US); Elsherbini, Adel, Tempe, 85284 (US); YU, Qiang, Saratoga, 95070 (US); Liff, Shawna, Scottsdale, 85255 (US); CHOI, Beomseok, Chandler, 85286 (US)
(74) Representative: Goddar, Heinz J.

(57) **Abstract**

Apparatus and methods are disclosed. In one example, a semiconductor package includes a first die that has a first surface and a first electrical lead at or near the first surface. The semiconductor package also includes a substrate that has a second surface and is coupled to the first die at a first interface. The substrate also includes a first electrode at or near the second surface and at least a first portion of an integrated passive device that is coupled to the first electrode. The first electrode is aligned with and coupled to the first electrical lead across the first interface.

## Description

### FIELD OF THE INVENTION

The invention relates to semiconductor packages. More specifically, the invention relates to hybrid bonding of components in semiconductor packages.

### BACKGROUND

Recent advances in hybrid bonding technology for emerging high-volume wafer-to-wafer and die-to-wafer 3D stacking provide sub-micron alignment accuracy in the X, Y (laterally) directions and the Z (vertically) direction between the two wafers/dies that are hybrid bonded at an interface. Additionally, hybrid bonding allows little to no die gap in the Z direction with covalent bonding across the interface.

### BRIEF DESCRIPTION OF THE DRAWINGS

FIG. 1 is a cross-section illustration of an example semiconductor package with a hybrid bonded standoff substrate between two dies.
FIG. 2 is a cross-section illustration of another example semiconductor package with a hybrid bonded standoff substrate between two dies.
FIG. 3 is a cross-section illustration of yet another example semiconductor package with a hybrid bonded standoff substrate between two dies.
FIG. 4A is a top view of an example planar, multilayer capacitor fabricated in a standoff substrate.
FIG. 4B is a top view of another example planar capacitor fabricated in a standoff substrate.
FIG. 4C is a top view of an example planar serpentine capacitor fabricated in a standoff substrate.
FIG. 5A is a schematic illustration of an example switched capacitor voltage regulator.
FIG. 5B is a schematic cross-sectional view of the switched capacitor voltage regulator, described in FIG. 5A, fabricated in a standoff substrate between two dies.
FIG 6. is a schematic illustration of an example radio frequency front end with one or more standoff substrates between dies.
FIG. 7 is an example visual manufacturing flow diagram to manufacture a semiconductor package with a hybrid bonded standoff substrate between two dies.
FIG. 8 is another example visual manufacturing flow diagram to manufacture a semiconductor package with a hybrid bonded standoff substrate between two dies.
FIG. 9 is a flow diagram of an example method to manufacture a three-dimensional integrated passive device between dies.

The figures are not to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular. In general, the same reference numbers will be used throughout the drawing(s) and accompanying written description to refer to the same or like parts. As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another. Notwithstanding the foregoing, in the case of a semiconductor device, "above" is not with reference to Earth, but instead is with reference to a bulk region of a base semiconductor substrate (e.g., a semiconductor wafer) on which components of an integrated circuit are formed. Specifically, as used herein, a first component of an integrated circuit is "above" a second component when the first component is farther away from the bulk region of the semiconductor substrate than the second component. As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween. As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly that might, for example, otherwise share a same name. As used herein, "approximately" and "about" refer to dimensions that may not be exact due to manufacturing tolerances and/or other real world imperfections. As used herein "substantially real time" refers to occurrence in a near instantaneous manner recognizing there may be real world delays for computing time, transmission, etc. Thus, unless otherwise specified, "substantially real time" refers to real time +/- 1 second. As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events. As used herein, "processor circuitry" is defined to include (i) one or more special purpose electrical circuits structured to perform specific operation(s) and including one or more semiconductor-based logic devices (e.g., electrical hardware implemented by one or more transistors), and/or (ii) one or more general purpose semiconductor-based electrical circuits programmed with instructions to perform specific operations and including one or more semiconductor-based logic devices (e.g., electrical hardware implemented by one or more transistors). Examples of processor circuitry include programmed microprocessors, Field Programmable Gate Arrays (FPGAs) that may instantiate instructions, Central Processor Units (CPUs), Graphics Processor Units (GPUs), Digital Signal Processors (DSPs), XPUs, or microcontrollers and integrated circuits such as Application Specific Integrated Circuits (ASICs). For example, an XPU may be implemented by a heterogeneous computing system including multiple types of processor circuitry (e.g., one or more FPGAs, one or more CPUs, one or more GPUs, one or more DSPs, etc., and/or a combination thereof) and application programming interface(s) (API(s)) that may assign computing task(s) to whichever one(s) of the multiple types of the processing circuitry is/are best suited to execute the computing task(s).

### DETAILED DESCRIPTION

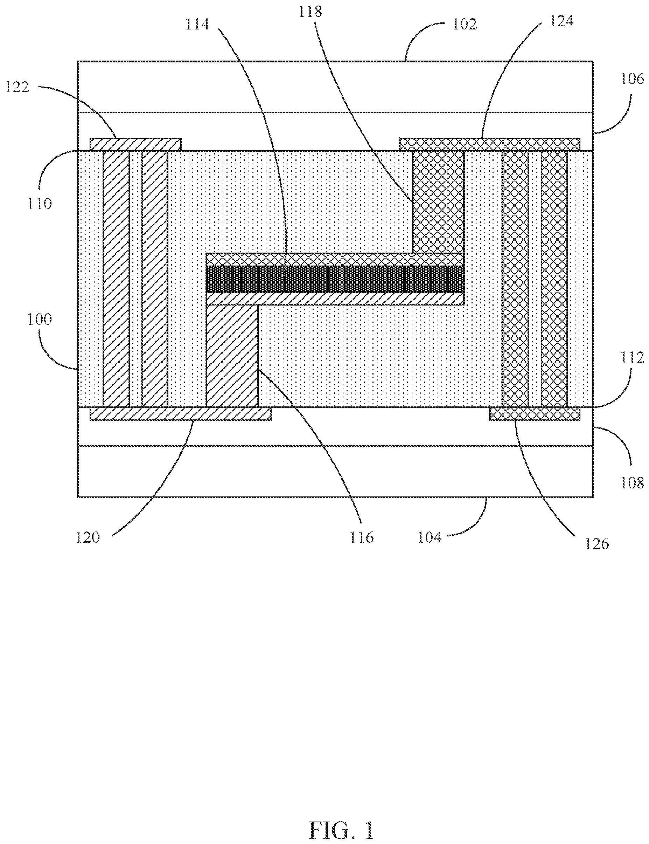

FIG. 1 is a cross-sectional illustration of an example semiconductor package with a hybrid bonded standoff substrate between two dies. The example standoff substrate 100 is part of a semiconductor package that includes two dies 102 and 104. The term "die" can be interchangeably used herein with wafer, chip, or substrate. In some examples, each of the two dies 102 and 104 may be a general purpose compute die, an I/O controller, a memory chip, a radio frequency transceiver, a chip with a customized set of circuitry to implement one or more functions, or any other type of die that could be a portion of a semiconductor package.

The example dies 102 and 104 have their own internal circuitry that could include a number state machines and/or circuitry to implement one or more memory structures (e.g., transistors, diodes, logic gates, etc.), connections, and/or other circuitry (e.g., capacitors). Additionally, the dies 102 and 104 include backends 106 and 108, respectively. In some examples, the backends 106 and 108 are built with silicon oxide (SiO₂) and to communicatively couple the dies 102 and 104 to other parts of the wafer stack in the illustrated semiconductor package. In the example shown, the dies 102 and 104 are electrically coupled to each other through the standoff substrate 100, which serves as an intermediary coupling device between the dies 102 and 104. In some examples, the standoff substrate may have electrical, optical, and/or any other signal lines to transfer signals between die 102 and die 104.

In the illustrated example, the surface of the backend 106 that is physically bonded (e.g., attached) to the standoff substrate 100 is referred to as the interface 110. Additionally, in the illustrated example, the surface of the backend 108 that is physically bonded (e.g., attached) to the standoff substrate 100 is referred to as the interface 112. In some examples, the surface of the backend 106 of die 102 is hybrid bonded to the adjacent surface of the standoff substrate 100 at interface 110 and/or the surface of the backend 108 of the die 104 is hybrid bonded to the adjacent surface of the standoff substrate 100 at interface 112. Hybrid bonding the backends of the dies to the standoff substrate 100 allows for a precise 3-D stacked configuration that results in thick dielectric layers compared to traditional backend layers of the dies.

In some examples, the standoff substrate 100 between the two dies may be fabricated with a thickness ranging from between 5µm up to 400µm. The example standoff substrate 100 of FIG. 1 is fabricated with one or more dielectric materials. In some examples, the dielectric constant of a material used in fabricating the standoff substrate 100 can range between 3 (e.g., organic polymers), 4 (e.g., glass), and up to 12 (e.g., silicon -11.7 and/or alumina -10).

In the illustrated example, the standoff substrate includes an integrated passive device 114. In some examples, the integrated passive device is a capacitor. In some examples, the capacitor is made of a high-K dielectric material. High-K dielectric materials used in some examples include, but are not limited to, BaSrTiO₃ (e.g., a dielectric constant of -1000 at 1GHz), PbZr₁₋ₓTixO₃ (PZT), PMNT, TiTaO, BiNbO, Bi_{1.5}Zn_{1.0}Nb_{1.5}O₇ (BZN). In other examples, the integrated passive device 114 is another passive device such as a resistor, an inductor, or a filter. In many examples, the dielectric is referred to as one or more oxide layers. A "passive" device is defined herein as a device that does not require an electrical current as an input to power its ability to perform its function(s).

In some examples, certain high-K dielectric materials such as those listed above can require up to 1000-degrees Centigrade temperatures for fabrication. Many organic materials used for fill material in known die stacking processes do not have the ability to be fabricated at temperatures above around 250-degrees Centigrade. Thus, hybrid bonding is utilized to allow for high-K materials to be deposited on standoff substrates made of glass or other materials. As discussed, the fabrication process allows standoff substrates to be fabricated at a wide range of thicknesses for different purposes (e.g., 5µm up to 400µm or more). Additionally, hybrid bonding allows for multiple standoff substrates to be stacked on top of each other. Thus, in some examples, two or more standoff substrates (e.g., 100 and one or more other standoff substrates) are stacked between dies 102 and 104. Furthermore, in some examples, the multiple stacked standoff substrates may be of different/heterogeneous thicknesses.

In the illustrated example, the integrated passive device 114 is a planar multi-layer capacitor. In some examples, the high-K dielectric material of the capacitor 114 has a thickness between tens of nanometers to thousands of nanometers. Although a single high-K layer capacitor is shown in FIG. 1, in other examples a multilayer capacitor can be fabricated.

The example high-K capacitor is coupled to a first electrode structure 116 (electrode 116) within the standoff substrate 100 and to a second electrode structure 118 (electrode 118) also within the standoff substrate 100. In some examples, the electrodes 116 and 118 are metal wires (e.g., vias or other structures that conduct electricity). The different cross-hatching shown in FIG. 1 illustrates the electrode structures on the opposite sides of the high-K capacitor 114 (the integrated passive device).

The example electrodes 116 and 118 are coupled to the backends 106 and 108 through electrical leads at or near the surface of the backend of each die. "Near" the surface is defined herein as being close enough to the surface of a die backend to allow the flow of electricity across the interfaces 110 and 112 once the hybrid bonding is complete. More specifically, the electrode 116 is electrically coupled to the backend 108 through the electrical lead 120. An electrical lead can also be referred to herein as an electrical pad or a bond pad. The electrode 116 is electrically coupled to the backend 106 through the electrical lead 122. The electrode 118 is electrically coupled to the backend 106 through the electrical lead 124. And the electrode 118 is electrically coupled to the backend 108 through the electrical lead 126.

In some examples, using the standoff substrate 100 to contain (e.g., disposed within the three dimensional structure of standoff substrate 100) one or more integrated passive devices, such as integrated passive device 114, allows for such passive devices to not reside within one or more of the backends 106 and 108. This provides more room for other structures, circuitry, and/or other components within backends 106 and 108 and/or simplifies their functionality and/or lessens their associated costs. The fabrication of the example standoff substrate 100 is decoupled from the fabrication of the two dies 102 and 104, thus, more materials can be used to build integrated passive device 114 with no traditional fabrication boundary issues, such as temperature, wafer bow, etc.

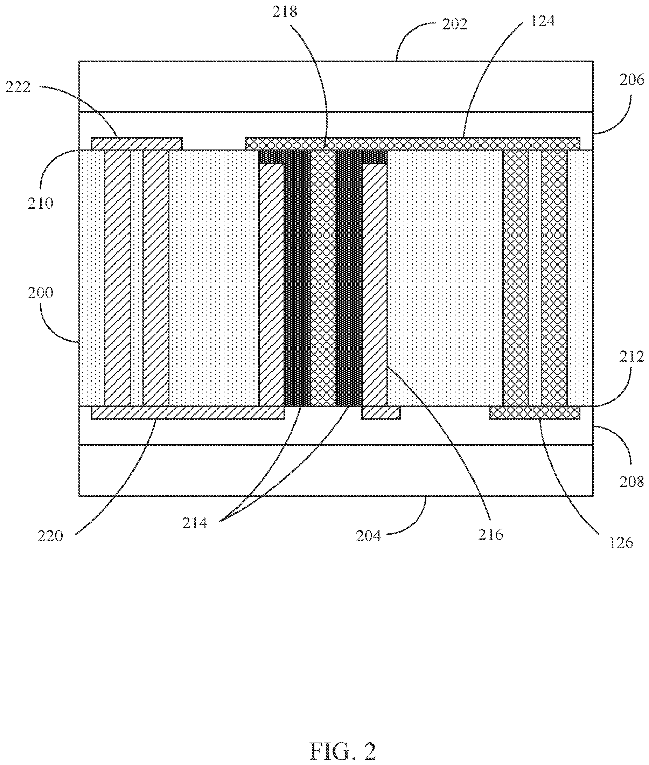

FIG. 2 is a cross-sectional view of another example semiconductor package with a hybrid bonded standoff substrate between two dies. While FIG. 1 illustrated a planar multilayer capacitor, FIG. 2 illustrates a thru-configuration 3D capacitor. The example standoff substrate 200 of FIG. 2 is part of a semiconductor package that includes two dies 202 and 204. Again, like in FIG. 1, each of the two dies 202 and 204 may be a general purpose compute die, an I/O controller, a memory chip, a radio frequency transceiver, a chip with a customized set of functions, or any other type of die that could located in a semiconductor package.

In the illustrated example, each die 202 and 204 includes a backend 206 and 208, respectively. In some examples, the backends 206 and 208 are built with SiO₂ to communicatively couple the dies 202 and 204 to other parts of the wafer stack in the illustrated semiconductor package. In the example shown, the dies 202 and 204 are electrically coupled to each other through the standoff substrate 200, which serves as an intermediary coupling device between the dies 202 and 204.

The surface of the example backend 206 is hybrid bonded to the standoff substrate 200 across interface 210. Additionally, the surface of the example backend 208 is hybrid bonded to the standoff substrate 200 across interface 212.

In some examples, the standoff substrate 200 between the two dies may be fabricated with a thickness ranging from between 5µm up to 400µm with one or more dielectric materials.

In the illustrated example, the standoff substrate includes an integrated passive device 214. In some examples, the integrated passive device 214 is a three-dimensional (3D) capacitor. In the illustrated example, the 3D capacitor 214 is a thru-configuration 3D capacitor where the 3D capacitor structure is present through the entire thickness of the standoff substrate 200, from the interface 210 to the interface 212.

In some examples, the aspect ratio (e.g., height:width) the 3D capacitor illustrated in FIG. 2 may be 20:1 or lower. In other examples, higher aspect ratios may be utilized. Since FIG. 2 is a cross section, the cylindrical nature of the 3D capacitor is not illustrated, but it should be understood that the electrode 216 wraps around the 3D capacitor 214 and the 3D capacitor 214 wraps around electrode 218.

More specifically, the example high-K 3D capacitor is coupled to the first electrode structure 216 (electrode 216) within the standoff substrate 100 and to the second electrode structure 218 (electrode 218) also within the standoff substrate 100. In some examples, the electrodes 216 and 218 are metal wires (e.g., vias or other structures that conduct electricity). The different cross-hatching shown in FIG. 2 illustrates the electrode structures on the opposite sides of the high-K 3D capacitor 214.

The example electrode 216 is electrically coupled to the backend 208 through the electrical lead 220 and electrically coupled to the backend 206 through the electrical lead 222. The example electrode 218 is electrically coupled to the backend 206 through the electrical lead 224 and electrically coupled to the backend 208 through the electrical lead 226.

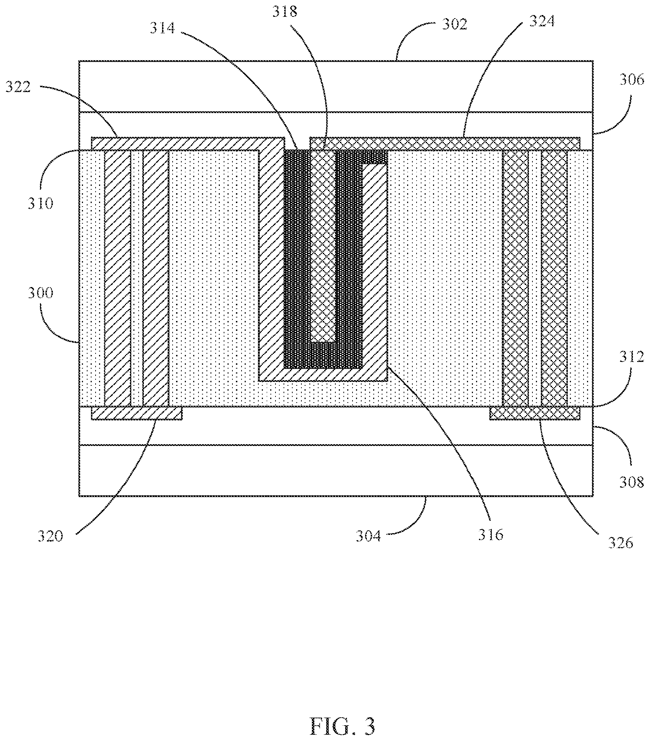

FIG. 3 is a cross-sectional illustration of yet another example semiconductor package with a hybrid bonded standoff substrate between two dies. The cross-sectional view in FIG. 3 illustrates a blind-configuration 3D capacitor. The example standoff substrate 300 is part of a semiconductor package that includes two dies 302 and 304. Again, like in FIG. 1 and FIG. 2, each of the two dies 302 and 304 may be a general purpose compute die, an I/O controller, a memory chip, a radio frequency transceiver, a chip with a customized set of functions, or any other type of die that could be located in a semiconductor package.

In the illustrated example, each die 302 and 304 includes a backend 306 and 308, respectively. In some examples, the backends 306 and 308 are built with SiO₂ to communicatively couple the dies 302 and 304 to other parts of the wafer stack in the illustrated semiconductor package. In the example shown, the dies 302 and 304 are electrically coupled to each other through the standoff substrate 300, which serves as an intermediary coupling device between the dies 302 and 304.

The surface of the example backend 306 is hybrid bonded to the standoff substrate 300 across interface 310. Additionally, the surface of the example backend 308 is hybrid bonded to the standoff substrate 300 across interface 312.

In some examples, the standoff substrate 300 between the two dies may be fabricated with a thickness ranging from between 5µm up to 400µm with one or more dielectric materials.

In the illustrated example, the standoff substrate includes an integrated passive device 314. In some examples, the integrated passive device 314 is a three-dimensional (3D) capacitor. In the illustrated example, the 3D capacitor 314 is a blind-configuration 3D capacitor where the structure of the capacitor is not present through the entire thickness of the standoff substrate. Rather the capacitor 314 is at one surface, for example the standoff substrate 300 surface that is adjacent to interface 310. In some examples, the aspect ratio (e.g., height:width) of the 3D capacitor illustrated in FIG. 3 may be 20:1 or lower. In other examples, higher aspect ratios may be utilized.

The example 3D capacitor 314 may go through a majority of the height of the standoff substrate 300 but it does not reach the surface of the standoff substrate 300 adjacent to the interface 312. Again, like in FIG. 2, the cylindrical nature of the blind-configuration 3D capacitor 314 is not illustrated in FIG. 3, but it should be understood that the electrode 316 wraps around the 3D capacitor 314 and the 3D capacitor 314 wraps around electrode 318. In other embodiments, in addition to a cylindrical shape, the example 3D capacitor can be any shape that is achievable through any known fabrication process.

More specifically, the example high-K 3D capacitor is coupled to the first electrode structure 316 (electrode 316) within the standoff substrate 300 and to the second electrode structure 318 (electrode 318) also within the standoff substrate 300. The different cross-hatching shown in FIG. 3 illustrates the electrode structures on the opposite sides of the high-K 3D capacitor 314.

The example electrode 316 is electrically coupled to backend 308 through the electrical lead 320 and electrically coupled to the backend 306 through the electrical lead 322. The example electrode 318 is electrically coupled to the backend 306 through the electrical lead 324 and electrically coupled to the backend 208 through the electrical lead 226.

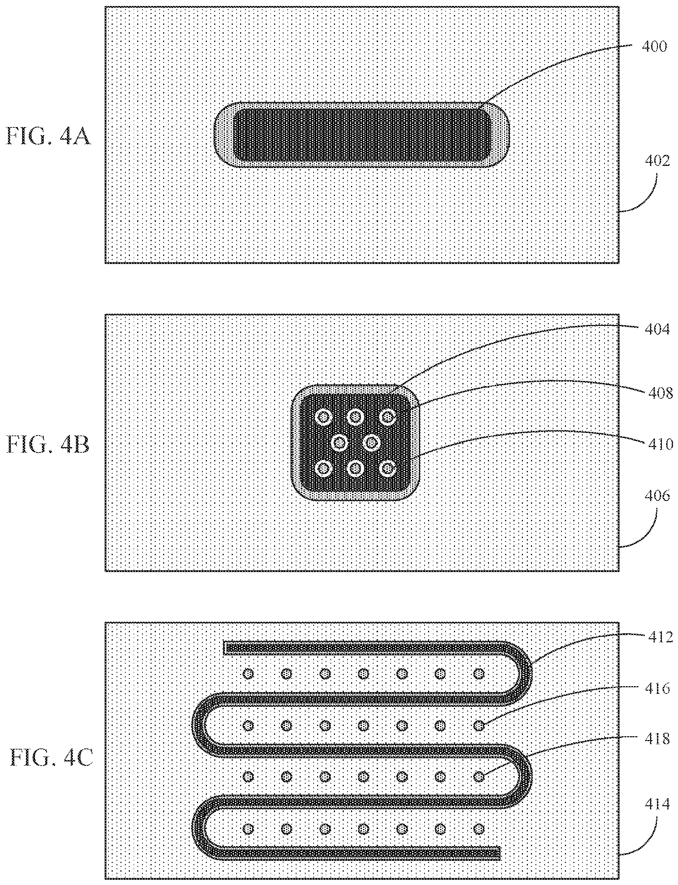

FIGs. 4A, 4B and 4C are top views of three example of high-K dielectric capacitors in standoff substrates. Although three specific capacitor structures are shown, there are many other examples of different shapes and sizes of capacitors.

FIG. 4A is a top view of an example planar, multilayer capacitor 400 fabricated in a standoff substrate 402.

FIG. 4B is a top view of another example planar capacitor 404 fabricated in a standoff substrate 406. The example planar capacitor 406 shown in FIG. 4B includes via perforations (e.g., vias 408 and 410, among others). In some examples, the perforations of power or signal vias (e.g., 408, 410, etc.) may be present to facilitate connections between top and bottom dies (e.g., dies 302 and 304 in FIG. 3).

FIG. 4C is a top view of an example planar serpentine capacitor 412 fabricated in a standoff substrate 414. The example serpentine capacitor 412 shown in FIG. 4C also includes via perforations (e.g., vias 416 and 418, among others). In other examples, many other high-K dielectric capacitor configurations may be fabricated for a number of reasons, including filling space available between dies with integrated passive devices for greater functionality in smaller or more space efficient packages. In other examples, integrated passive devices such as resistors, inductors, and filters also may have any number of layout configurations in the standoff substrate fabrication process.

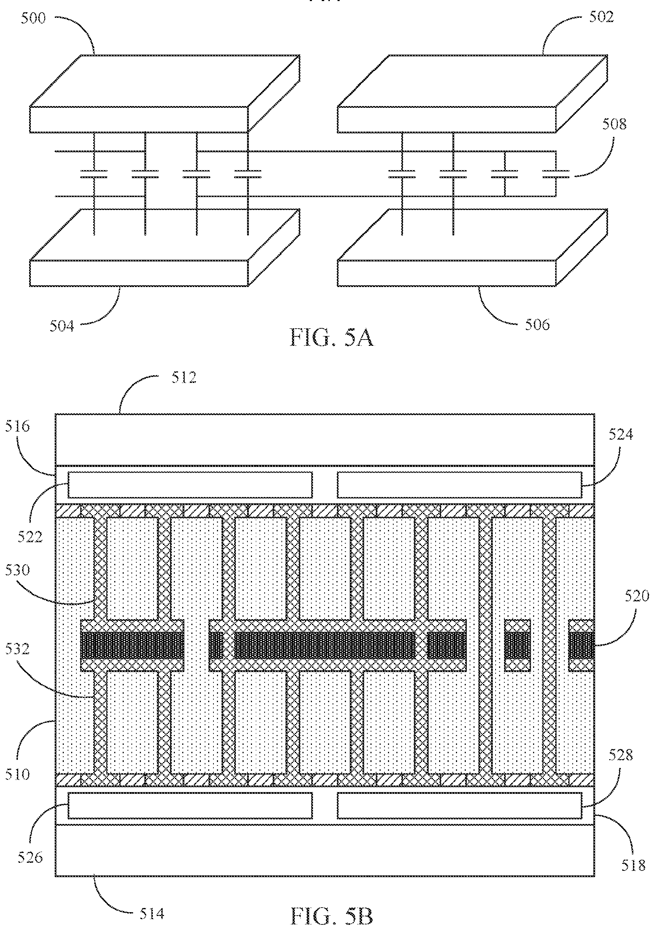

FIG. 5A is a schematic illustration of an example switched capacitor voltage regulator and FIG. 5B is a cross-sectional view of the FIG. 5A switched capacitor voltage regulator fabricated in a standoff substrate between two dies. In some examples, FIG. 5A has four electrical switches 500, 502, 504, and 506 that are coupled to a series of capacitors 508. In some examples, the electrical switches 500-506 are implemented in the backend of stacked dies. In some examples, electrical switches may be MOSFETs, GaNFETs, or another type of electrical switch. In a standard stacked implementation, a high power switched capacitor voltage regulator would have high parasitic resistance and inductance when routing electrical wires to the capacitors 508.

Alternatively, FIG. 5B illustrates the FIG. 5A type of switched capacitor voltage regulator in a standoff substrate between two dies. The example standoff substrate 510 is hybrid bonded to each of the two dies 512 and 514 through their backends 516 and 518. In the illustrated example, the standoff substrate 510 includes multiple distributed contacts to a high-K planar capacitor, such as the one illustrated in FIG. 1. In other examples, the high-K capacitor can be formed into any one or more of a number of configurations, such as those configurations shown in FIG. 2, FIG. 3, and FIGs 4A-4C.

In the illustrated example, the high-K planar capacitor 520 is coupled to the electrical switches 522, 524, 526, and 528 through a series of distributed electrodes (e.g., 530 and 532) that are coupled to a series of electrical leads/pads that are coupled to the switches 522-528. Without the standoff substrate 510 enabling this capacitor location, the capacitor(s) utilized to enable the switched capacitor voltage regulator shown in FIG. 5A would usually be integrated into the backend of a die and would require a substantially larger area of implementation leading to increased interconnection parasitics.

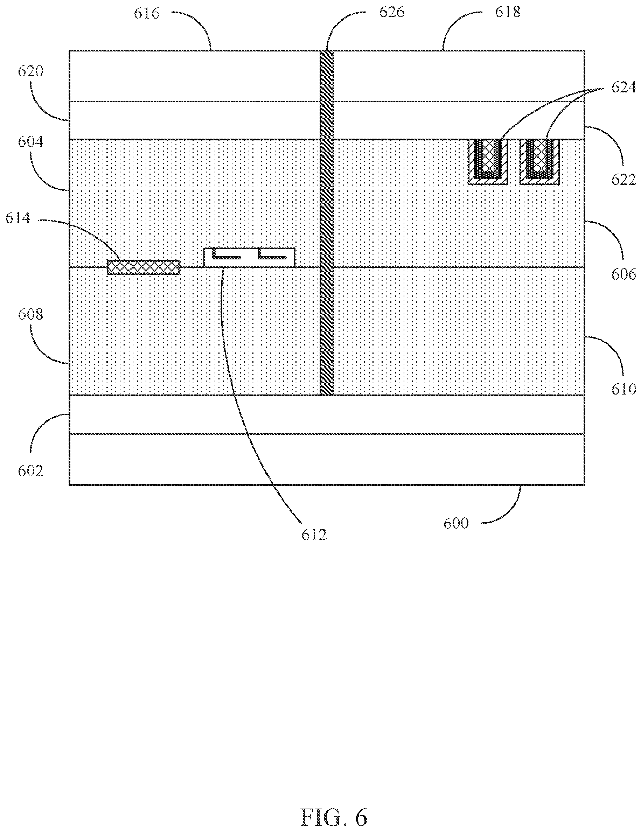

FIG 6. is a schematic illustration of an example radio frequency (RF) front end (FE) with one or more standoff substrates between dies. In some examples, the front end includes a first die that may that have one or more high-Q inductors and RF filters. In the illustrated example, a base die 600 shown includes functionality for baseband, analog-to-digital converters, transmission logic (TRX), and clocking, among other functionalities. The example die 600 is fabricated on a scaled node for efficiency and high performance.

The example die 600 includes a backend 602 that is coupled to one or more standoff substrates 604 and 606 across an interface. In the illustrated example, the standoff substrates 604 and 606 have additional portions 608 and 610 that function as an optional lid for hermeticity for a hermetic cavity 612. The example hermetic cavity is a cavity in the standoff substrate 604 where the leads for one or more film bulk acoustic resonator (FBAR) or surface acoustic wave (SAW) filters are housed. This cavity is hermetically sealed by hybrid bonding the lid 608 to the standoff substrate 604. The material utilized to fabricate the example standoff substrate 604 and the lid 608 may be compatible with processes for high-Q RF filter fabrication. Typically, CMOS and high-Q RF filter fabrication processes are not compatible. Thus, the example illustrates the results of separately fabricating each type of needed component in separate substrates and then hybrid bonding them together to create a monolithic RF FE with CMOS and RF filter functionality.

As described above, the illustrated example includes a high-Q filter, which utilizes one or more high-Q material inductors, such as inductor 614. Inductor 614 may be at or near the surface of standoff substrate 604 that is adjacent to lid 608.

Additionally, the RF FE shown has one or more chiplet dies 616 and 618 coupled to the base die 600 through the standoff substrates 604 and 606. The example dies 616 and 618 are referred to as "chiplets" due to their focused sets of functional purposes. The example dies 616 and 618 are coupled to the standoff substrates 604 and 606 through backends (e.g., a SiO₂ backend) 620 and 622. Each example standoff substrate is designed to take a specific subset of passive functions out of the respective chiplet die it is coupled to. For example, the die 616 can be a power amplifier (PA) and/or a low noise amplifier (LNA) on a leading RF manufacturing node. A PA/LNA die will utilize high-Q RF filters. The high-Q RF filter components in the hermetic cavity 612 and the inductor 614 allow for such a filter to be fabricated in the standoff substrate 604 with a much more customizable and adaptable process, as opposed to in the chiplet.

The illustrated example may have a switch on a CMOS node in the chiplet die 608. This example circuitry may benefit from one or more high-K capacitors 624, which are fabricated in the standoff substrate 606. In the illustrated example, the die 616 and the standoff substrate 604 may need to be isolated from the die 618 and the standoff substrate 606. In this example, a separation between those two portions of the full RF FE package with a filled material 626 is shown.

For clarity, power vias and other interconnect traces for signals and I/O are not shown in FIG. 6. In some examples, such traces communicatively couple integrated passive devices (e.g., the filters in hermetic cavity 612, the inductor 614, and the capacitors 624) to base die 600 and/or chiplet dies 616 and 618.

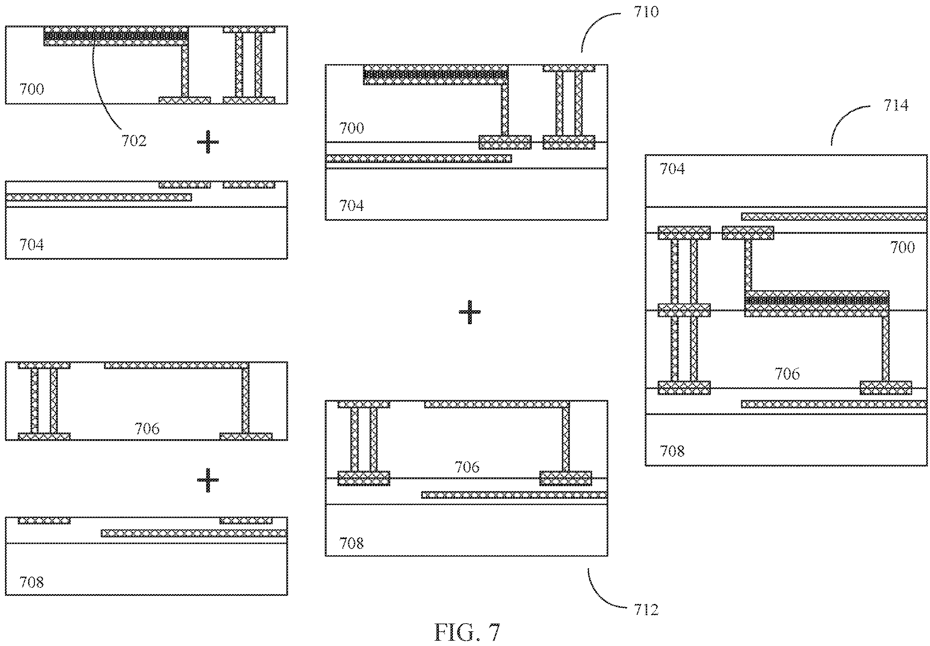

FIG. 7 is a manufacturing flow diagram of an example of manufacturing a semiconductor package with a hybrid bonded standoff substrate between two dies. The flow in FIG. 7 moves from left to right with two independent manufacturing flow streams that are combined in the final step.

In some examples, a standoff substrate 700 is fabricated with an entire high-K capacitor 702. The entire capacitor includes all electrode and oxide layers (as described above in reference to FIG. 1). For example, fabricating the entire high-K capacitor 702 in the standoff substrate 700 can be utilized as a manufacturing method to create the standoff substrate 510 shown in FIG. 5B. In the illustrated example, once the fabrication of the standoff substrate 700 with the high-K capacitor 702 is complete, the standoff substrate 700 is hybrid bonded to the backend of die 704 to create the combination 710 that combines the standoff substrate 700 with the die 704.

On the other side of the manufacturing flow, a second standoff substrate 706 is fabricated. In this example, the standoff substrate 706 includes bond pads, vias, and/or other electrical coupling methods to hybrid bond the standoff substrate 706 with a second die 708 to create combination 712.

The final step in this manufacturing process flow is to rotate standoff substrate 700 in combination 710 to align the surface that includes the electrodes and the high-K dielectric capacitor 702 to the adjacent surface of standoff substrate 706 in combination 712 to hybrid bond the two standoff substrates together in combination 714.

The final result is a semiconductor package stack of two dies and two standoff substrates that have properties similar to

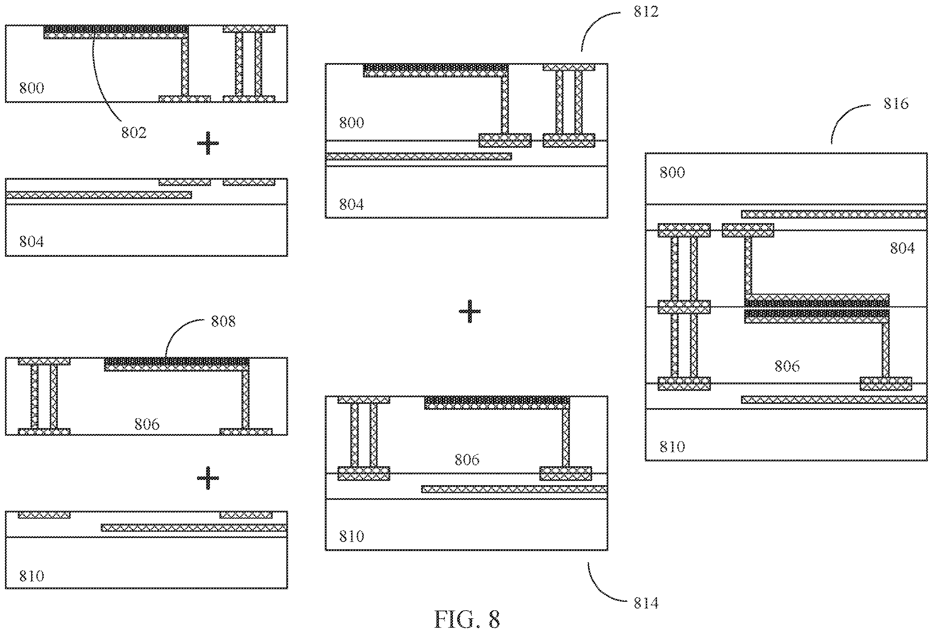

FIG. 8 is a manufacturing flow diagram of another example of manufacturing a semiconductor package with a hybrid bonded standoff substrate between two dies. The flow in FIG. 8 moves from left to right with two independent manufacturing flow streams that are combined in the final step.

In some examples, a standoff substrate 800 is fabricated with a portion of a high-K capacitor 802. In the illustrated example, half of the high-K capacitor (802) is fabricated on the standoff substrate 800 and the other half of the high-K capacitor (808) is fabricated on the standoff substrate 806. In some examples, when the high-K capacitor is split into two sides, half of the electrode and oxide layers are on each standoff substrate (800 and 806, respectively). In the illustrated example, once both the standoff substrates (800 and 806) are fabricated, then the standoff substrate 800 is hybrid bonded to the backend of die 804 to create the combination 812 and the standoff substrate 806 is hybrid bonded to the backend of die 810 to create the combination 814. Next, the combination 812 is rotated to align the high-K capacitor 802 with the high-K capacitor 808. And finally, the surfaces of standoff substrates 800 and 806 that are facing each other in FIG. 8 are hybrid bonded to create the final combination 816.

In other examples, there is may be one or more additional standoff substrates between dies 804 and 810 in combination 816. For example, instead of two standoff substrates, as illustrated, there may be three or more. In yet other examples, there may be just a single standoff substrate. Additionally, in other examples one or more standoff substrates that are hybrid bonded may have different thicknesses.

In some examples, the die (e.g., 804 and/or 810) creates a rigid structure to allow the safe movement, alignment, and placement of each of the standoff substrates (e.g., 800 and/or 806) during a hybrid bonding process. Depending on the thickness of a given standoff substrate, something like a die or what is herein referred to as a carrier wafer may be employed for such mechanical movements. As described, standoff substrates can be anywhere from 5µm to 400µm or more in thickness. For standoff substrates on the thicker end of that range, the standoff substrate structure itself may be robust enough to not worry about breaking during the mechanical movements and handling.

With thinner standoff substrates, the die utilized in the semiconductor package that is hybrid bonded to the standoff substrate gives the standoff substrate a firm backbone during movement and handling. In examples where there are three or more standoff substrates consecutively stacked, a carrier wafer can be manufactured and temporarily utilized. When a carrier wafer is utilized, the standoff substrate is either fabricated on a carrier wafer or fabricated by itself and then immediately attached (e.g., bonded) to the carrier wafer. Then the thin standoff substrate can be moved around to allow for hybrid bonding to another standoff substrate or another wafer/substrate. Once the thin standoff substrate is hybrid bonded to a permanent adjacent standoff substrate or wafer/die, then the carrier wafer can be debonded from the thin standoff wafer. In some examples, the debonding can utilize any known debonding process. The threshold to determine what is too thin for movement without the help of a bonded die or carrier wafer may be material and manufacturing process specific.

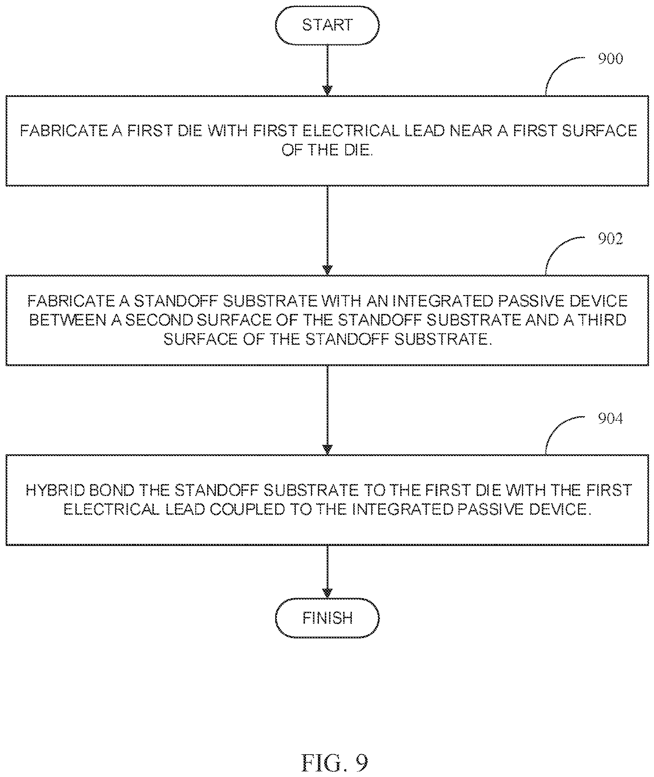

FIG. 9 is a flow diagram of an example method to manufacture a three-dimensional integrated passive device between dies.

The manufacturing process begins by fabricating a first die with a first electrical lead near a first surface of the die (block 900). In some examples, the first die can be a compute die, an I/O controller die, a custom die, or any other functional die. In some examples, the electrical lead can be any form of electrically conducting material in the form of a pad, or a via, or a metal line, or another type of lead. In the described example, the manufacturing process deposits the lead at or near the surface of the die. If the lead is near the surface but not at the surface, the lead needs to be close enough to allow for a free flow of electricity from the lead to another device attached to the surface of the first die at the lead location.

The manufacturing process continues by fabricating a standoff substrate with an integrated passive device between a second surface of the standoff substrate and a third surface of the standoff substrate (block 902). For clarity, the surfaces described on the standoff substrate are a "second" and a "third" to fully distinguish those surfaces from the "first" surface described on the first die. The qualifying descriptions of each surface are simply meant to clearly show that there are three distinct surfaces described in the manufacturing process flow of FIG. 9. In some examples, the standoff substrate can be fabricated out of any effective dielectric material, such as glass or Silicon. In some examples, the integrated passive device can be any type of passive device, such as a capacitor, a resistor, an inductor, a filter, or any other known passive device. In some examples, the integrated passive device is enclosed within the three-dimensional volume of the standoff substrate. In some examples, a surface of the integrated passive device is located at the surface of the standoff substrate. As described, the standoff substrate has at least two surfaces (defined as a second and a third in the broader manufacturing flow example). In some examples, the standoff substrate is a wafer with an X-Y plane and a Z-height/dimension. In some of these examples, the second surface and third surface are at opposites ends of the Z-dimension of the thickness of the standoff substrate.

The manufacturing process continues by hybrid bonding the standoff substrate to the first die with the first electrical lead coupled to the integrated passive device (block 904). In some examples, the hybrid bonding flow includes a stage that creates very precise alignment of the elements that are to be bonded at the respective surfaces. In some examples, the first electrical lead is a bond pad that is bonded through the hybrid bonding process to another bond pad at the end of an electrical line (e.g., electrode) that is also coupled to the integrated passive device. In other examples, a portion of the integrated passive device is deposited/located at the surface of the standoff substrate being bonded and there is no need for intermediary electrically conductive lines (such as a via) to electrically couple the electrical lead to the integrated passive device or to an electrode adjacent to at least one layer of the integrated passive device. In these embodiments, a portion of the integrated passive device can be directly attached/bonded through the hybrid bonding process to the electrical lead in the first die.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements or method actions may be implemented by, e.g., the same entity or object. Additionally, although individual features may be included in different examples or claims, these may possibly be combined, and the inclusion in different examples or claims does not imply that a combination of features is not feasible and/or advantageous.

From the foregoing, it will be appreciated that example apparatuses and methods have been disclosed that integrate three-dimensional passive components between dies. Disclosed apparatuses and methods integrate three-dimensional passive components between dies by enabling an intermediate standoff substrate fabrication process that is not part of CMOS manufacturing. Therefore, increased temperatures or unique/exotic materials can be employed. In this way low leakage, high-K (high density) capacitors can be developed.

Close integration of heterogeneously integrated voltage regulators (VRs) are also enabled by utilizing intermediate standoff substrates that have small (e.g., minimal) distance between the capacitor and the die. Additionally, when the capacitor is part of the connection between stacked dies, the structure itself enables voltage regulation topologies which were ineffective in the past due to the parasitic resistance and inductance added when routing to distant capacitors.

Similarly, locating RF filters within the standoff substrate enables close integration to PA/LNA and CMOS switch dies, which leads to reduced footprints of RF FEs and increased performance due to lower parasitic resistance and inductance when routing to distant IPDs.

Intermediate standoff substrate thickness is variable/heterogeneous and can be 10-50x thicker than traditional backend dielectric layer thicknesses (0.1-5um). This can also enable high-Q inductors since they can now be placed further away from the lossy silicon substrate.

Disclosed apparatus and methods of manufacture are accordingly directed to one or more improvement(s) in the operation of a machine such as a computer or other electronic and/or mechanical device.

Although certain example systems, methods, apparatus, and articles of manufacture have been disclosed herein, the scope of coverage of this patent is not limited thereto. On the contrary, this patent covers all systems, methods, apparatus, and articles of manufacture fairly falling within the scope of the claims of this patent. Example apparatus and methods to manufacture three-dimensional passive components between dies are disclosed herein. Further examples and combinations thereof include the following:
Example 1 includes a semiconductor package, comprising a first die, the first die having a first surface, a first electrical lead at or near the first surface of the first die, a substrate, the substrate having a second surface, the substrate coupled to the first die at a first interface, a first electrode at or near the second surface of the substrate, at least a first portion of an integrated passive device, the at least first portion of the integrated passive device in the substrate, the at least first portion of the first integrated passive device coupled to the first electrode, and the first electrode in alignment with and coupled to the first electrical lead across the first interface.
Example 2 includes the semiconductor package of example 1, wherein the at least first portion of the integrated passive device includes a high-K material.
Example 3 includes the semiconductor package of example 1, wherein the integrated passive device is a planar multilayer capacitor.
Example 4 includes the semiconductor package of example 1, wherein the integrated passive device is a 3D capacitor.
Example 5 includes the semiconductor package of example 1, wherein the first substrate is hybrid bonded to the first die at the first interface.
Example 6 includes the semiconductor package of example 1, further including a second die, the second die having a third surface, a second electrical lead at or near the third surface of the second die, the substrate having a fourth surface, the fourth surface opposite the second surface, the substrate coupled to the second die at a second interface, a second electrode at or near the fourth surface of the substrate, the first high-density electrically passive element coupled to the second electrode, and the second electrode in alignment with and coupled to the second electrical lead across the second interface.
Example 7 includes the semiconductor package of example 6, wherein the first die includes at least a first electrical switch coupled to the first electrical lead and the second die includes at least a second electrical switch coupled to the second electrical lead.
Example 8 includes the semiconductor package of example 6, wherein the substrate is hybrid bonded to the second die at the second interface.
Example 9 includes the semiconductor package of example 8, further including a radio frequency filter in the substrate.
Example 10 includes the semiconductor package of example 1, wherein the substrate is a first substrate, and further including a second substrate, the second substrate having a first surface, the second substrate coupled to the first substrate at a second interface, the first substrate having a third surface, the third surface opposite the second surface, and at least a portion of the first high-density electrically passive element at or near the fourth surface.
Example 11 includes the semiconductor package of example 10, further including a second electrode at or near the first surface of the second substrate, and the second electrode in alignment with and coupled to the at least portion of the first high-density electrically passive element across the second interface.
Example 12 includes the semiconductor package of example 10, further including a second high-density electrically passive element in the second substrate, at least a portion of the second high-density electrically passive element at or near the first surface of the second substrate, and the portion of the first high-density electrically passive element in alignment with and coupled to the portion of the second high-density electrically passive element across the second interface.
Example 13 includes the semiconductor package of example 10, wherein the second substrate is hybrid bonded to the first substrate at the second interface.
Example 14 includes the semiconductor package of example 10, wherein a thickness of the first substrate is between 5µm and 400µm.
Example 15 includes the semiconductor package of example 14, wherein a thickness of the second substrate is between 5µm and 400µm .
Example 16 includes a method of assembling a semiconductor package, comprising providing a first die with a first electrical lead near a first surface of the first die, providing a substrate with an integrated passive device between a second surface of the substrate and a third surface of the substrate, the third surface of the substrate opposite the second surface of the substrate, and hybrid bonding the substrate to the first die with the first electrical lead coupled to the integrated passive device to assemble a first portion of the semiconductor package.
Example 17 includes the method of example 16, wherein the fabricating of the substrate further includes fabricating a first electrode in the substrate further including coupling the first electrode to the integrated passive device.
Example 18 includes the method of example 17, wherein the hybrid bonding of the substrate to the first die further includes positioning at least a portion of the first electrode in the substrate in a position adjacent to the first electrical lead in the first die, and hybrid bonding at least a first portion of the first surface of the first die to at least a portion of the second surface of the substrate.
Example 19 includes the method of example 18, wherein the hybrid bonding of the substrate to the first die further includes bonding a first carrier wafer to the substrate prior to the hybrid bonding of the at least first portion of the first surface of the first die to the at least portion of the second surface of the substrate, and debonding the first carrier wafer from the substrate after the hybrid bonding of the at least first portion of the first surface of the first die to the at least portion of the second surface of the substrate.
Example 20 includes the method of example 19, further including fabricating a second die with a second electrical lead near a fourth surface of the second die.
Example 21 includes the method of example 20, further including hybrid bonding the second die to the substrate with the second electrical lead coupled to the integrated passive device to assemble the semiconductor package with an integrated passive component between the first and the second dies.
Example 22 includes the method of example 21, wherein the fabricating of the second die further includes fabricating a second electrode in the substrate, and coupling the second electrode to the integrated passive device.
Example 23 includes the method of example 22, wherein the hybrid bonding of the second die to the substrate further includes positioning at least a portion of the second electrode in the substrate in a position adjacent to the second electrical lead in the second die, and hybrid bonding at least a first portion of the fourth surface of the second die to at least a portion of the third surface of the first substrate.
Example 24 includes the method of example 19, wherein the substrate is a first substrate, and further including fabricating a second substrate with a second electrical lead near a first surface of the second substrate, and hybrid bonding the second substrate to the first substrate with the second electrical lead coupled to the integrated passive device to assemble a further portion of the semiconductor package with an integrated passive component between the first and second dies.

## Claims

1. A semiconductor package, comprising:
a first die, the first die having a first surface;
a first electrical lead at or near the first surface of the first die;
a substrate, the substrate having a second surface, the substrate coupled to the first die at a first interface;
a first electrode at or near the second surface of the substrate;
at least a first portion of an integrated passive device, the at least first portion of the integrated passive device in the substrate, the at least first portion of the first integrated passive device coupled to the first electrode; and
the first electrode in alignment with and coupled to the first electrical lead across the first interface.

2. The semiconductor package of claim 1, wherein the at least first portion of the integrated passive device includes a high-K material.

3. The semiconductor package of claim 1, wherein the integrated passive device is a planar multilayer capacitor.

4. The semiconductor package of claim 1, wherein the integrated passive device is a 3D capacitor.

5. The semiconductor package of claim 1, wherein the first substrate is hybrid bonded to the first die at the first interface.

6. The semiconductor package of claim 1, further including:
a second die, the second die having a third surface;
a second electrical lead at or near the third surface of the second die;
the substrate having a fourth surface, the fourth surface opposite the second surface, the substrate coupled to the second die at a second interface;
a second electrode at or near the fourth surface of the substrate, the first high-density electrically passive element coupled to the second electrode; and
the second electrode in alignment with and coupled to the second electrical lead across the second interface.

7. The semiconductor package of claims 1 and 6, wherein the first die includes at least a first electrical switch coupled to the first electrical lead and the second die includes at least a second electrical switch coupled to the second electrical lead.

8. The semiconductor package of claims 1 and 6, wherein the substrate is hybrid bonded to the second die at the second interface.

9. The semiconductor package of claims 6 and 8, further including:
a radio frequency filter in the substrate.

10. The semiconductor package of claim 1, wherein the substrate is a first substrate, and further including:
a second substrate, the second substrate having a first surface, the second substrate coupled to the first substrate at a second interface;
the first substrate having a third surface, the third surface opposite the second surface; and
at least a portion of the first high-density electrically passive element at or near the fourth surface.

11. The semiconductor package of claim 10, further including:
a second electrode at or near the first surface of the second substrate; and
the second electrode in alignment with and coupled to the at least portion of the first high-density electrically passive element across the second interface.

12. The semiconductor package of claim 10, further including
a second high-density electrically passive element in the second substrate, at least a portion of the second high-density electrically passive element at or near the first surface of the second substrate; and
the portion of the first high-density electrically passive element in alignment with and coupled to the portion of the second high-density electrically passive element across the second interface.

13. The semiconductor package of claim 10, wherein the second substrate is hybrid bonded to the first substrate at the second interface.

14. A method of assembling a semiconductor package, comprising:
providing a first die with a first electrical lead near a first surface of the first die;
providing a substrate with an integrated passive device between a second surface of the substrate and a third surface of the substrate, the third surface of the substrate opposite the second surface of the substrate; and
hybrid bonding the substrate to the first die with the first electrical lead coupled to the integrated passive device to assemble a first portion of the semiconductor package.

15. The method of claim 14, wherein the fabricating of the substrate further includes fabricating a first electrode in the substrate further including coupling the first electrode to the integrated passive device.
